(19) Europäisches Patentamt

European Patent Office

Office européen des brevets

(11) **EP 1 076 417 B1**

(12) **FASCICULE DE BREVET EUROPEEN**

(45) Date de publication et mention
de la délivrance du brevet:
**12.04.2006 Bulletin 2006/15**

(51) Int Cl.:
***H03M 1/36*** (2006.01)

(21) Numéro de dépôt: **00402281.0**

(22) Date de dépôt: **11.08.2000**

(54) **Circuit de répliement de signal, et cellule d'interpolation série d'un convertisseur analogique-numérique utilisant un tel circuit**

Signalfaltschaltung und serielle Interpolationszelle eines diese benutzenden Analog-Digitalwandlers

Signal folding circuit and serial interpolation cell of an analog-digital converter using such a circuit

(84) Etats contractants désignés:
**AT BE CH CY DE DK ES FI FR GB GR IE IT LI LU MC NL PT SE**

(30) Priorité: **13.08.1999 FR 9910496**

(43) Date de publication de la demande:
**14.02.2001 Bulletin 2001/07**

(73) Titulaire: **Atmel Grenoble S.A.
38120 Saint Egreve (FR)**

(72) Inventeurs:
• **Gaillard, Christophe,
Thomson-CSF PID Brevets
94117 Arcueil Cedex (FR)**
• **Wingender, Marc,
Thomson-CSF PID Brevets
94117 Arcueil Cedex (FR)**
• **Le Tual, Stéphane,
Thomson-CSF PID Brevets
94117 Arcueil Cedex (FR)**

(74) Mandataire: **Lucas, Laurent Jacques
Marks & Clerk France
31-33 Avenue Aristide Briand
94117 Arcueil Cedex (FR)**

(56) Documents cités:
**EP-A- 0 600 788          WO-A-92/08288
WO-A-97/09788**

• **PATENT ABSTRACTS OF JAPAN vol. 1995, no. 11, 26 décembre 1995 (1995-12-26) -& JP 07 210615 A (TARA TEC:KK), 11 août 1995 (1995-08-11)**

**Description**

La présente invention concerne une cellule de repliement de signal, utilisable notamment pour réaliser une cellule d'interpolation série d'un convertisseur analogique-numérique à interpolation. Elle s'applique par exemple à des convertisseurs dont l'architecture comporte une partie dite d'interpolation série et qui nécessitent une grande précision.

Une demande de brevet français FR-A-2699025 décrit un convertisseur analogique-numérique à circuit de repliement comportant une partie d'interpolation série. Un des intérêts d'un convertisseur analogique-numérique à repliement est qu'il permet d'économiser des comparateurs dans sa partie analogique. En particulier, la conversion du signal ne joue pas sur la comparaison de l'amplitude réelle de ce dernier avec une série de comparateurs analogiques. Les bits de conversion de poids successifs sont obtenus, par simples combinaisons analogiques, en fonction de l'appartenance de l'amplitude du signal à des intervalles définis par des tensions de référence régulièrement distribuées, ces intervalles étant de plus en plus faible au fur et à mesure que les bits de conversion s'approchent du bit de poids faible. Ainsi, un signal Vin est appliqué à l'entrée d'au moins deux circuits de repliement, dont la fonction est de fournir des signaux dits « repliés » Vr1, Vr1b, Vr2, Vr2b, ayant une amplitude qui varie avec l'amplitude du signal d'entrée Vin selon une fonction périodique, de forme sensiblement sinusoïdale. Les fonctions Vr1 et Vr1b sont en opposition de phase, de même les fonctions Vr2 et Vr2b sont en opposition de phase. Les fonctions Vr1 et Vr2 sont quant à elles en quadrature. Les différences (Vr1-Vr1b), (Vr2-Vr2b) s'annulent périodiquement pour des valeurs de tension d'entrée qui sont les tensions de référence précitées. A partir de ces différences, une cellule d'interpolation établit des signaux de même allure générale que les différences de signaux repliés, mais qui s'annulent pour des valeurs de tension d'entrée Intermédiaires entre les valeurs de référence. Ainsi, si une cellule d'interpolation comporte en entrée $2^n+1$ tensions de références telles que précédemment définies, elle présente $2^{n+1}+1$ tensions dites interpolées. Une cellule permet donc de créer un bit d'information supplémentaire. A partir d'un circuit de repliement initial, les cellules d'interpolation mises en cascade permettent donc d'obtenir les différents bits successifs de conversion d'une grandeur analogique, en partant du bit de poids fort. Les cellules d'interpolation sont classiquement des cellules dites « multiplieur de Gilbert », notamment décrite dans la demande de brevet français précitée, mais aussi dans la demande internationale WO 92/08288.

La brève description qui précède d'un convertisseur analogique-numérique à circuit de repliement montre l'importance de la précision des tensions de référence. Or, ces dernières sont obtenues dans les circuits d'interpolation comportant des circuits de repliement de signal, notamment les cellules de Gilbert, dont le principe de fonctionnement est basé sur des aiguillages de courant dans des paires de branches différentielles comportant des transistors bipolaires ou de type MOS, câblées en cascade. De cette architecture, il s'ensuit que les tensions de référence dépendent notamment des tensions base-émetteur Vbe de transistors en cascade. Cette tension dépend elle-même du courant des transistors et d'autres paramètres extérieurs tels que par exemple la température. La précision des tensions de référence, et donc du résultat de la conversion analogique-numérique, s'en trouve donc par conséquent affectée. Par ailleurs, pour une tension crête donnée la cascade de tensions Vbe limite la tension utile, c'est-à-dire disponible pour la conversion.

Une demande de brevetr japonais JP 07210615 A décrit un circuit permettant un repliement de signal composé de deux paires de branches de transistors.

Un but de l'invention est de pallier les inconvénients précités en limitant le nombre de tensions base-émetteur Vbe en cascade dans le circuit de repliement de signal d'une cellule d'interpolation. A cet effet, l'invention a pour objet une cellule de repliement de signal telle que définie par la revendication 1.

L'invention a encore pour objet une cellule d'interpolation pour un convertisseur analogique-numérique à interpolation, utilisant des cellules telles que celle définie précédemment.

L'invention a pour principaux avantage qu'elle permet une amélioration de la rapidité de conversion, qu'elle permet d'améliorer les performances en vitesse notamment de convertisseur analoglque-numérique sans pour autant augmenter de façon significative les tensions d'alimentation, qu'elle permet d'améliorer simplement ces performances de vitesse et qu'elle est simple à mettre en oeuvre.

D'autres caractéristiques et avantages de l'invention apparaîtront à l'aide de la description qui suit faite en regard de dessins annexés qui représentent :

- la figure 1, un exemple d'architecture de convertisseur analogique-numérique à cellules d'interpolation utilisant des circuits de repliement ;
- les figures 2a et 2b, un exemple de formes d'onde repliées, en entrée et en sortie d'une cellule d'interpolation ;
- la figure 3, un exemple de circuit de repliement selon l'art antérieur, dit cellule de Gilbert ;
- la figure 4, un exemple de réalisation possible d'un circuit de repliement utilisé dans une cellule selon l'invention ;
- la figure 5, une illustration du fonctionnement du circuit précédent présentant en fonction d'une tension d'entrée Vin, les formes d'ondes des courant passant dans des résistances de collecteurs et les formes d'onde des tensions de sortie ;
- la figure 6, un exemple de réalisation possible d'une cellule d'interpolation selon l'invention ;
- la figure 7, une illustration du fonctionnement d'un circuit de combinaison de courants effectuant un décalage des formes d'onde à l'entrée d'un circuit de repliement selon l'invention, présentant les formes d'onde de courant de collecteur et de tension dans une résistance en fonction de la tension d'entrée précitée ;

- la figure 8, un autre exemple de réalisation possible d'un circuit de décalage des formes d'onde en entrée d'un circuit de repliement selon l'invention ;

- la figure 9, une illustration du fonctionnement du circuit de la figure 8 présentant une forme d'onde décalée en fonction de deux autres formes d'onde

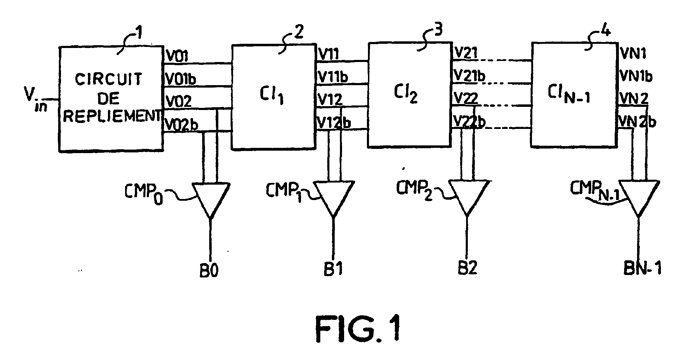

La figure 1 présente de façon schématique un exemple d'architecture de convertisseur analogique-numérique à circuit de repliement. La tension à convertir Vin est présente à l'entrée d'un premier circuit de repliement 1. Pour des raisons de clarté de description, des circuits non directement liés à l'objet de l'invention n'ont pas été représentés en figure 1, c'est par exemple le cas de l'échantillonneur bloqueur généralement disposé an entrée d'un convertisseur analogique-numérique. Les sorties du convertisseur sont représentées par des bits $B_0$, $B_1$, $B_2$ ....$B_N$ ayant la valeur 0 ou 1, le convertisseur codant les grandeurs analogiques sur N+1 bits. Pour mémoire, la conversion numérique approche par exemple la grandeur analogique d'entrée Vin selon la relation suivante, dans le cas d'un code binaire naturel :

$$Vin = A_0 \left( B_0 2^{-1} + B_1 2^{-2} + B_2 2^{-3} + \ldots\ldots B_N 2^{-(N+1)} \right) \qquad (1)$$

où $A_0$ représente l'amplitude maximum possible d'un signal à convertir.

Dans d'autres cas, la progression peut se faire en code GRAY. Il y a alors décodage du code GRAY en code binaire.

Les bits $B_0$, $B_1$, $B_2$ ....$B_N$ sont issus respectivement de comparateurs $CMP_0$, $CMP_1$, $CMP_2$, ...$CMP_N$. Il est à noter qu'en sortie du premier circuit de repliement 1, en tête, on peut avoir plusieurs bits d'information. Cela dépend notamment du nombre de repliements, ou encore du nombre de références.

Le bit de poids fort $B_0$ est obtenu en sortie d'un premier comparateur $CMP_0$ qui lui-même est câblé en sortie du premier circuit de repliement 1 précité. Ce dernier réalise, à partir de la tension analogique d'entrée Vin, quatre tensions repliées $V_{01}$, $V_{01b}$, $V_{02}$, $V_{02b}$ fournies par ses quatre sorties.

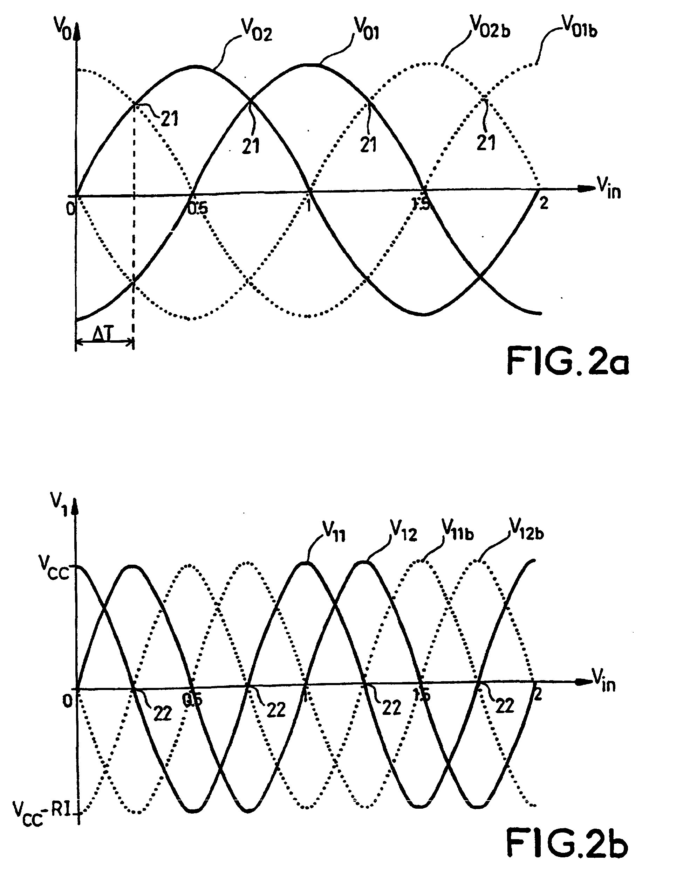

La figure 2a illustre par quatre courbes les quatre tensions repliées $V_{01}$, $V_{01b}$, $V_{02}$, $V_{02b}$ précitées dans un système d'axes. Plus précisément, les courbes représentatives de la figure 2a illustrent les fonctions de transfert entre l'entrée Vin du circuit de repliement 1 et chacune de ses quatre sorties. En d'autres termes, l'axe des abscisses représentant la tension d'entrée Vin, l'axe des ordonnées représente la tension $V_0$ présente sur chacune des quatre sorties du circuit 1 en fonction de la tension d'entrée Vin. Chacune des quatre courbes $V_{01}$, $V_{01b}$, $V_{02}$, $V_{02b}$ représente alors respectivement les variations des tensions repliées $V_{01}$, $V_{01b}$, $V_{02}$, $V_{02b}$ en fonction de la tension d'entrée Vin, ces courbes représentatives ayant même référence que leur tensions associées, pour des raisons de simplicité. Les variations des tensions repliées $V_{01}$, $V_{01b}$, $V_{02}$, $V_{02b}$ sont périodiques et de forme sensiblement sinusoïdale. Une période représente la plage de conversion ou encore l'amplitude maximum admissible en entrée du convertisseur, c'est-à-dire notamment la valeur $A_0$ de la relation (1) précédente, dans le cas où le premier circuit de repliement 1 comporte cinq références, soit deux bits d'information. Celle-ci est représentée en valeur relative sur l'axe des abscisses de la figure 2a par la valeur 2. Les courbes $V_{01}$ et $V_{01b}$ sont en opposition de phase, de même les courbes $V_{02}$ et $V_{02b}$ sont en opposition de phase. Les courbes $V_{01}$ et $V_{02}$ sont en quadrature, $V_{02}$ étant en avance sur $V_{01}$ et passant par le point origine 0.

Les courbes $V_{02}$, $V_{02b}$ permettent de déterminer le bit de poids fort $B_0$, ce dernier étant égal à 1 si la tension d'entrée Vin est supérieure ou égale à $A_0/2$, représenté par la valeur relative 1 sur l'axe des abscisses de la figure 2a, ou égal à 0 si elle est inférieure à cette valeur. A cet effet, les sorties du circuit de repliement 1 qui comportent les tensions $V_{02}$, $V_{02b}$ sont câblées à l'entrée du premier comparateur logique $CMP_0$ de telle sorte que la sortie de ce dernier est égale à 1 lorsque $V_{02}$ est supérieur ou égal à $V_{02b}$ et est égal à 0 dans le cas contraire.

Les courbes $V_{01}$, $V_{01b}$ forment un bit d'information à elles seules en code GRAY. Les quatre sorties du premier circuit de repliement 1 sont reliées aux quatre entrées d'un deuxième circuit de repliement 2. De façon connue, ce dernier réalise un repliement supplémentaire de la tension d'entrée Vin tel qu'illustré par quatre courbes représentatives $V_{11}$, $V_{11b}$, $V_{12}$, $V_{12b}$ en figure 2b, dans un même système d'axes que celui de la figure 2a. Il fournit donc en sortie quatre tensions repliées $V_{11}$, $V_{11b}$, $V_{12}$, $V_{12b}$ destinées à être câblées à un autre circuit de repliement 3 et, pour deux d'entre elles à indiquer la valeur du bits $B_1$ de poids suivant. Les circuits de repliement 2, 3, 4, qui suivent le premier 1 et qui sont prévus pour être montés en cascade sont encore appelés cellules d'interpolation. Les courbes $V_{11}$, $V_{11b}$, $V_{12}$, $V_{12b}$ qui représentent des variations des tensions de sortie de la cellule d'interpolation 2 en fonction de la tension d'entrée Vin sont périodiques, de période moitié de celle des précédentes courbes $V_{01}$, $V_{01b}$, $V_{02}$, $V_{02b}$, et sensiblement sinus-didales. Les courbes $V_{11}$ et $V_{11b}$ sont en opposition de phase, de même les courbes $V_{12}$ et $V_{12b}$ sont en opposition de phase. Les courbes $V_{11}$ et $V_{12}$ sont en quadrature, $V_{12}$ étant en avance sur $V_{11}$ et passant par le point origine 0.

Le bit $B_1$, qui suit immédiatement le bit de poids fort $B_0$, est donc obtenu en sortie d'un deuxième comparateur

CMP$_1$. Ce dernier est câblé en sortie du deuxième circuit de repliement 2, de telle sorte que le bit B$_1$ soit égal à 1 lorsque V$_{12}$ est supérieur ou égal à V$_{12b}$ et est égal à 0 dans le cas contraire.

De façon analogue à l'obtention de B$_1$, les circuits d'interpolation suivant 3, 4 et les comparateurs associés CMP$_1$, ... CMP$_{N-1}$ permettent d'obtenir les bits suivant B$_2$, ...B$_N$. Un circuit d'interpolation 2, 3, 4, monté en cascade, effectue un repliement supplémentaire par rapport au circuit d'interpolation précédent et permet ainsi d'obtenir un bit d'information supplémentaire, comme l'illustre le passage du bit B$_0$ au bit B$_1$ tel que décrit précédemment. Les intersections des courbes V$_{11}$, V$_{11b}$, V$_{12}$, V$_{12b}$ sur l'axe des abscisses représentent ce que l'on a appelé précédemment des tensions de référence. Ces intersections correspondent elles-mêmes aux intersections intermédiaires 21 des courbes V$_{01}$, V$_{01b}$, V$_{02}$, V$_{02b}$, situées entre les valeurs de référence de ces dernières 0, 0,5, 1, 1,5 et 2.

Selon que la tension d'entrée Vin est inférieure ou supérieure à une tension de référence, la valeur du bit de poids correspondant, B$_1$, dans l'exemple relatif à la figure 2a, est égale à 0 ou 1. La précision de ces tensions de référence est donc un paramètre très important. En particulier, il peut donc être important que ces valeurs de référence dépendent le moins possible de paramètres non maîtrisables, tel que par exemple la température. Ces valeurs de référence sont obtenues dans des circuits d'interpolation comportant des circuits de repliement de signal, notamment les cellules de Gilbert, dont le principe de fonctionnement est basé sur des aiguillages de courant dans des paires de branches différentielles comportant des transistors bipolaires, câblées en cascade.

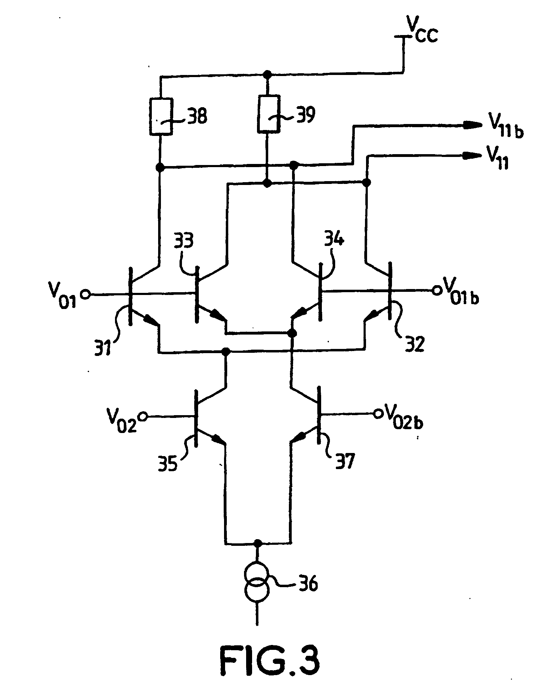

La figure 3 montre un circuit de repliement de tension selon l'art antérieur, à titre d'exemple une cellule de Gilbert, réalisable par ailleurs en technologie MOS. Un tel circuit permet par exemple d'obtenir les tensions V$_{12}$ et V$_{12b}$ de la figure 2b à partir des quatre tensions V$_{01}$, V$_{01b}$, V$_{02}$, V$_{02b}$ de la figure 2a. Le circuit de la figure 3 comporte deux paires différentielles 31, 32, 33, 34 formées de transistors bipolaires NPN. Une première paire 31, 32 est reliée par l'intermédiaire d'un premier transistor suiveur 35, dont la base est commandée par la tension V$_{02}$, à une source de courant 36, et la deuxième paire 33, 34 est reliée à cette même source par l'intermédiaire d'un deuxième transistor suiveur 37, dont la base est commandée par la tension V$_{02b}$. La tension V$_{01}$ est reliée à la base d'un transistor 31, 33 de chaque paire. De même, la tension V$_{01b}$ est reliée à la base d'un transistor 32, 34 de chaque paire. Le collecteur du transistor 31 de la première paire est relié avec le collecteur d'un transistor 34 de la deuxième paire à une tension stabilisée Vcc, par l'intermédiaire d'une première résistance 38, les collecteurs des deux autres transistors étant reliés à cette même tension stabilisée Vcc par l'intermédiaire d'une deuxième résistance 39. Le point de liaison de la première résistance 38 et des collecteurs fournit par exemple la tension V$_{11b}$ et le point de liaison de la deuxième résistance et des collecteurs fournit par exemple la tension V$_{11}$. Le principe de fonctionnement de ce circuit peut être succinctement rappelé. Pendant la demi-période pendant laquelle la tension V$_{01}$ est supérieure à la tension V$_{01b}$, le courant I de la source 36 ne peut passer que par les transistors 31, 33 dont la base est commandée par V$_{01}$. A l'intérieur de cette demi-période, le courant I passe d'une part dans la première résistance 38 et dans le premier transistor suiveur 35, et d'autre part dans la deuxième résistance 39 et le deuxième transistor suiveur 37 selon les valeurs relatives de V$_{02}$ et V$_{02b}$. La tension V$_{11}$, ou V$_{11b}$, varie donc entre Vcc - RI, cas où le courant passe dans la première résistance 38, à Vcc, cas où le courant I passe dans la deuxième résistance 39, R étant la valeur commune aux deux résistances 38, 39 reliées à la tension stabilisée Vcc. Pendant le quart de période où V$_{02}$ est supérieur à V$_{02b}$, la tension V$_{12b}$ s'établit de Vcc à Vcc - RI car le courant I passe par la première résistance 38. Puis pendant le deuxième quart de période où V$_{02b}$ est supérieur à V$_{02}$, la tension V$_{11b}$ s'établit de Vcc - RI à Vcc, car le courant ne passe plus par la première résistance 38 mais par la deuxième 39. Le phénomène est analogue pendant la demi-période où la tension V$_{01b}$ est supérieure à la tension V$_{01}$, si bien que la tension V$_{11b}$ évolue selon une période deux fois moindre que celle qui régit la variation de V$_{01}$, V$_{01b}$, V$_{02}$, V$_{02b}$. Le repliement de tension est ainsi effectué. La tension V$_{11}$ évolue de façon analogue à la tension V$_{11b}$, mais en opposition de phase.

Une cellule d'interpolation comporte un deuxième circuit de repliement analogue à celui de la figure 3, mais où les tensions V$_{01}$, V$_{01b}$, V$_{02}$, V$_{02b}$ sont reliées différemment pour obtenir les tensions en quadrature V$_{12}$, V$_{12b}$. Sur la figure 2b, les valeurs extrêmes Vcc et Vcc - RI ont été représentées. L'origine des axes 0, correspond alors à la tension milieu entre ces deux tensions. Les tensions de références introduites par une cellule d'interpolation dépendent de l'intersection des courbes de tensions repliées à son entrée, V$_{01}$, V$_{01b}$, V$_{02}$, V$_{02b}$.

De l'architecture de la figure 3, il s'ensuit que les tensions de référence, qui dépendent notamment des différences de tensions parmi V$_{01}$, V$_{01b}$, V$_{02}$, V$_{02b}$, dépendent donc des tensions base-émetteur Vbe de transistors en cascade. La tension base-émetteur Vbe varie notamment avec la température. La précision des tensions de référence, et donc la précision globale du convertisseur analogique-numérique s'en trouvent alors affectées. Par ailleurs, la double tension Vbe utilise inutilement de la tension disponible entre la source de courant 36 et Vcc, ce qui tend à augmenter la tension Vcc. L'augmentation de cette dernière pour conserver alors une plage de tension significative va à l'encontre d'une tendance générale qui diminue les tensions d'alimentation.

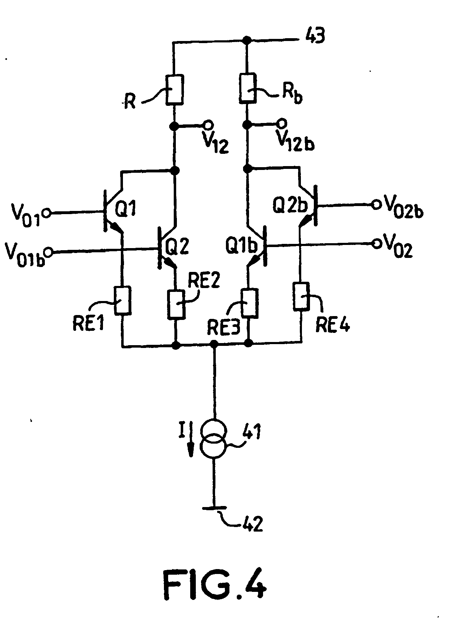

La figure 4 présente un exemple de réalisation possible d'un circuit utilisé dans une cellule de repliement selon l'invention, qui limite l'influence des tensions base-émetteur, permettant notamment une amélioration de la précision, mais aussi une baisse de la tension d'alimentation des convertisseurs analogique-numérique. Ce circuit de repliement comporte deux paires de branches différentielles alimentées par une même source de courant 41 reliée à une première borne d'alimentation 42. Chaque branche comporte au moins un transistor, les transistors d'une paire étant en parallèle sur les transistors de l'autre paire. Chaque groupe de deux transistors en parallèle est relié par une résistance commune respective R, $R_b$ à une deuxième borne d'alimentation 43, les deux sorties $V_{12}$, $V_{12b}$ du circuit de repliement étant les collecteurs réunis des deux groupes de transistors en parallèle. En d'autres termes, le collecteur d'un premier transistor Q1 est relié avec le collecteur d'un deuxième transistor Q2 à la deuxième borne d'alimentation par l'intermédiaire d'une première résistance R. De même, le collecteur d'un troisième transistor Q1b est relié avec le collecteur d'un quatrième transistor Q2b à la deuxième borne d'alimentation par l'intermédiaire d'une deuxième résistance $R_b$. Les émetteurs de ces quatre transistors sont reliés à la source de courant 41. Une première sortie $V_{12}$ est le point de liaison des collecteurs et de la première résistance R et la deuxième sortie $V_{12b}$ est le point de liaison des collecteurs et de la deuxième résistance $R_b$. Une première paire de branches différentielles comporte les transistors Q1 et Q2b, et la deuxième paire de branches différentielles comporte les transistors Q2 et Q1b. Une résistance d'émetteur RE1, RE2, RE3, RE4 est par exemple câblée entre chaque transistor Q1, Q2, Q1b, Q2b et la source de courant 41. Ces résistances permettent notamment d'obtenir des formes d'onde linéaires au voisinage de l'intersection 21, sur la figure 2a, des différentes courbes de tensions repliées $V_{01}$, $V_{01b}$, $V_{02}$, $V_{02b}$, ce qui est un élément important pour la précision des tensions de référence, qui sont définies par ces intersections 21. Il est en effet important que ces courbes se croisent à des niveaux où elles présentent un gain suffisamment important.

Pour simplifier la représentation, les tensions $V_{01}$, $V_{01b}$, $V_{02}$, $V_{02b}$ ont été placées directement aux entrées du circuit de repliement de la figure 4. En fait, pour assurer le bon fonctionnement du circuit, des dispositifs suiveurs sont par exemple intercalés entre les tensions $V_{01}$, $V_{01b}$, $V_{02}$, $V_{02b}$ et les entrées du circuit, notamment pour des questions d'adaptation d'impédance, et aussi pour des aspects de mode commun. Ces dispositifs sont par exemple des transistors montés de façon connue en suiveurs de tension. La chute de tension introduite par ces suiveurs est notamment neutralisée par la symétrie du montage.

Le fonctionnement du circuit de la figure 4 peut être expliqué en se référant aux figures 2a et 2b. A partir par exemple de quatre formes d'ondes $V_{01}$, $V_{01b}$, $V_{02}$, $V_{02b}$ telles qu'illustrées par la figure 2a, ce circuit permet d'obtenir les deux formes d'onde $V_{11}$, $V_{11b}$ de la figure 2b. Ces deux formes d'onde sont dites décalées, car leurs valeurs de références, qui correspondent à leurs intersections 22 sur l'axe des abscisses sont décalées par rapport aux valeurs de référence produites par les formes d'onde de la figure 2a. Les valeurs de référence des deux formes d'onde $V_{11}$, $V_{11b}$ de la figure 2b correspondent en fait aux intersections intermédiaires 21 des formes d'onde de la figure 2a. En considérant cette figure, de la valeur de référence 0 au premier point d'intersection intermédiaire 21, lorsque $V_{01b}$ est supérieure aux autres tensions, le courant I de la source de courant 41 passe dans le transistor Q2 commandé par $V_{01b}$. Puis, conformément aux valeurs relatives des tensions entre le premier point d'intersection intermédiaire 21 et la valeur de référence 1, le courant I passe successivement dans le transistor Q1b commandé par $V_{02}$ jusqu'à l'intersection intermédiaire comprise entre les valeurs de référence 0,5 et 1, puis enfin par le transistor Q1 commandé par $V_{01}$, de ce point d'intersection jusqu'à la valeur 1.

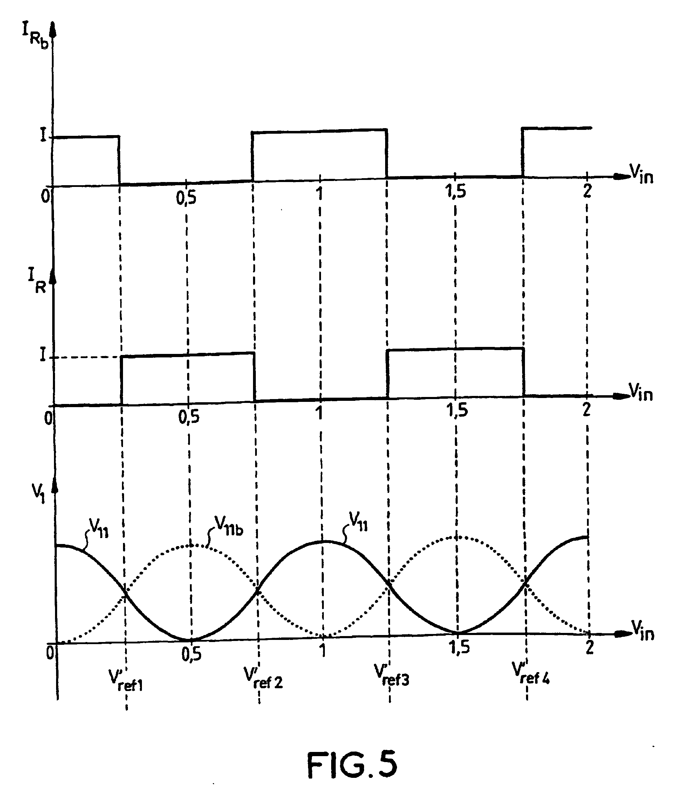

La figure 5a illustre alors le passage correspondant dans les résistances R et $R_b$, ces deux dernières ayant la même valeur ohmique. Les formes d'onde de courant des résistances R et $R_b$, notées respectivement $I_R$ et $I_{Rb}$, sont données dans deux systèmes d'axes respectifs en fonction des valeurs relatives de la tension d'entrée Vin. Ainsi, de 0 au premier point d'intersection intermédiaire 21, le courant 1 passe dans la résistance $R_b$ et non dans la résistance R. Puis, jusqu'au point d'intersection intermédiaire 21 compris entre 0,5 et 1, le courant I passe dans la résistance R et non dans la résistance $R_b$. Enfin, de ce point intermédiaire 21 jusqu'à la valeur de référence 1, le courant I passe dans la résistance $R_b$ et non dans la résistance R.

Le fonctionnement du circuit peut de même être expliqué pendant la demi-période suivante, c'est-à-dire entre les valeurs de référence relatives 1 et 2 de la figure 2a. De la valeur relative 1 au point d'intersection intermédiaire 21 suivant, c'est toujours le transistor Q1 qui conduit le courant I, car ayant la tension de base, $V_{01}$, la plus élevée. La résistance $R_b$ continue donc à conduire le courant jusqu'à ce point intermédiaire, alors que la résistance R reste sans courant. Puis, jusqu'au point d'intersection compris entre les valeurs de référence 1,5 et 1, le transistor Q2b conduit le courant, ayant la tension de base, $V_{02b}$, la plus élevée. C'est alors la résistance R qui est traversée par le courant I. Enfin, jusqu'à la valeur 2, le courant Q1b, commandé par la tension $V_{01b}$ qui redevient la plus élevée, conduit à nouveau le courant I, qui passe alors de nouveau dans la résistance $R_b$.

Les formes d'onde au niveau des sorties sont illustrées dans un troisième système d'axes sur la figure 5. Lorsque la résistance R se met à conduire, la tension de sortie $V_{11}$ passe de la tension Vcc, présente à la borne 43, à la tension Vcc - RI, alors que la tension de sortie $V_{11b}$ passe de Vcc - RI à Vcc. Les formes d'onde $V_{11}$ et $V_{11b}$ sont alors bien en opposition de phase et se coupent à des valeurs $V'_{ref1}$, $V'_{ref2}$, $V'_{ref3}$, $V'_{ref4}$ équidistantes chacune des valeurs de référence 0, 0,5, 1, 1,5 et 2 de la figure 2a qui les entourent, pourvu que ces intersections se produisent là où les courbes sont linéaires. Cela peut être obtenu en jouant notamment sur les valeurs des résistances d'émetteurs RE1, RE2, RE3, RE4. Les valeurs précitées $V'_{ref1}$, $V'_{ref2}$, $V'_{ref3}$, $V'_{ref4}$ constituent les nouvelles valeurs de référence créées par le circuit de repliement de la figure 4. Ce dernier a été décrit pour le repliement des tensions $V_{01}$, $V_{01b}$, $V_{02}$, $V_{02b}$, il fonctionne bien entendu pour le repliement de toutes formes d'ondes d'ordre supérieur, notamment dans une cascade de cellules d'interpolation dans un convertisseur analogique-numérique.

Un circuit selon l'invention, tel qu'illustré par la figure 4, permet par repliement des formes d'onde $V_{01}$, $V_{01b}$, $V_{02}$, $V_{02b}$ d'obtenir ce que l'on a appelé précédemment les tensions repliées décalées $V_{11}$ et $V_{11b}$. Pour réaliser une cellule d'interpolation série telle que définie relativement à la figure 1, il faut adjoindre au circuit de repliement de la figure 4, un autre circuit qui permette d'obtenir les tensions repliées $V_{12}$ et $V_{12b}$, que l'on peut appeler tensions repliées directes. A cet effet, on peut par exemple adjoindre au circuit de la figure 4 un autre circuit identique, muni d'un montage complémentaire qui permet d'obtenir des formes d'onde en quadrature, $V_{12}$ et $V_{12b}$.

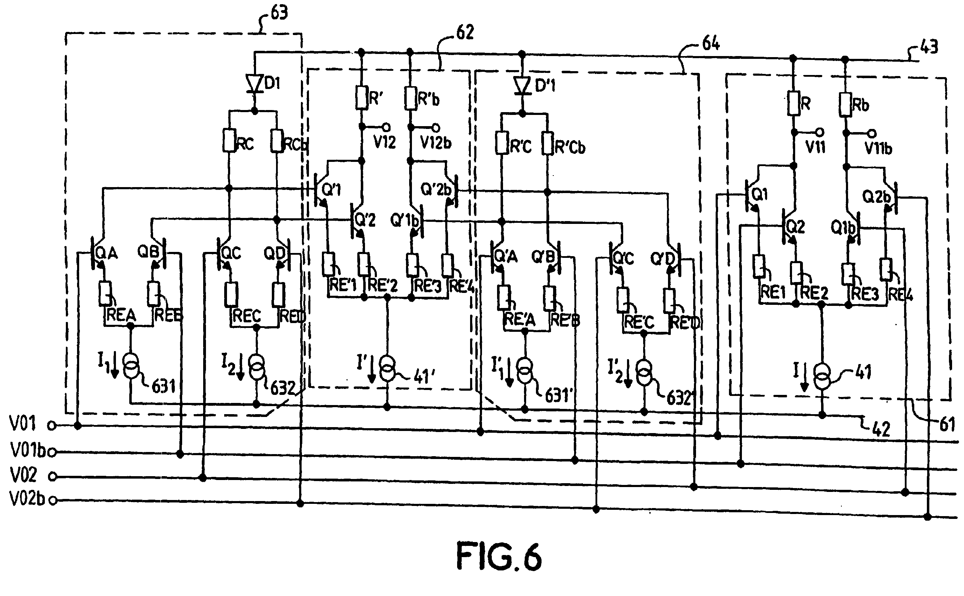

La figure 6, présente un exemple de réalisation possible d'une cellule d'interpolation, munie de deux circuits de repliement selon l'invention. Cette cellule comporte donc un circuit 61 identique à celui de la figure 4, et reçoit sur ses entrées les tensions $V_{01}$, $V_{01b}$, $V_{02}$, $V_{02b}$ comme décrit relativement à cette figure. En d'autres termes, la tensions $V_{01}$ attaque la base du transistor Q1, la tensions $V_{01b}$ attaque la base du transistor Q2, la tensions $V_{02}$ attaque la base du transistor Q1 b et la tensions $V_{02b}$ attaque la base du transistor Q2b. Les cellules comportent un deuxième circuit 62 tel que celui de la figure 4, comportant les mêmes éléments que le précédent 61, ces derniers, dont les caractéristiques fonctionnelles peuvent néanmoins être différentes, comportent les mêmes références mais ces dernières sont distinguées par le signe « ' ».

Contrairement au circuit 61 qui fournit les tensions repliées décalées $V_{11}$ et $V_{11b}$, le circuit 62 qui fournit sur ses deux sorties les tensions repliées directes $V_{12}$ et $V_{12b}$, ne reçoit pas directement les tensions $V_{01}$, $V_{01b}$, $V_{02}$, $V_{02b}$. Ainsi, le circuit de repliement 62 reçoit sur ses quatre entrées, les deux sorties d'un premier circuit 63 de combinaison de courants et les deux sorties d'un deuxième circuit 64 de combinaison de courants. Chaque circuit de combinaison de courant comporte par exemple deux paires différentielles alimentées chacune par une source de courant respective 631, 632, 631', 632' et ayant des résistances de collecteur Rc, $Rc_b$, R'c, $R'c_b$ communes. Toujours pour chaque circuit de combinaison de courants 63, 64, une paire reçoit comme entrées les tensions $V_{01}$ et $V_{01b}$, et l'autre paire reçoit comme entrées les tensions $V_{02}$ et $V_{02b}$. Les deux sorties d'un circuit de combinaison de courants sont prises sur les résistances de collecteurs Rc, $Rc_b$, R'c, $R'c_b$.

Plus précisément, un circuit 63 de combinaison de courants comporte un premier transistor QA, un deuxième transistor QB, un troisième transistor QC et un quatrième transistor QD, les deux premiers transistors QA, QB formant la première paire différentielle et les deux autres QC, QD formant la deuxième paire différentielle. Les collecteurs du premier transistor QA et du troisième transistor QC sont reliés à la première résistance Rc, alors que les collecteurs des deuxième et quatrième transistors QB, QD sont reliés à la deuxième résistance $Rc_b$. Les émetteurs des deux premiers transistors QA, QB sont reliés à une première source de courant 631 et les émetteurs des deux autres transistors sont reliés à la deuxième source de courant 632. De préférence, pour permettre notamment l'obtention de signaux bien linéaires, les émetteurs sont reliés à ces sources de courant 631, 632 par des résistances REA, REB, REC, RED. Ces sources de courant fournissent par exemple le même courant. Le point de connexion des collecteurs des deux premier et troisième transistors QA, QC et de la résistance Rc forme une première sortie du circuit 63, qui est par exemple connectée à la base du transistor Q'1 du circuit de repliement 62. De même, le point de connexion des collecteurs des deux autres transistors QB, QD et de la résistance $Rc_b$ forme une deuxième sortie du circuit 63, qui est par exemple connectée à la base du transistor Q'2 du circuit de repliement 62. Les résistances de collecteur Rc, $Rc_b$ sont par ailleurs reliées au potentiel Vcc, c'est-à-dire à la deuxième borne 43 précitée. Pour empêcher la saturation des transistors QA, QB, QC, QD, ces résistances Rc, $Rc_b$ sont par exemple reliées à cette deuxième borne 43 par l'intermédiaire d'une diode D1. Les tensions $V_{01}$, $V_{01b}$, $V_{02}$, $V_{02b}$ attaquent par exemple respectivement les bases des transistors QA, QB, QC, QD. Le deuxième circuit 64 de combinaison de courants comporte les mêmes composants que le premier 63, ces éléments étant distingués par le signe « ' » sur la figure 6. En particulier, les tensions $V_{01}$, $V_{01b}$, $V_{02}$, $V_{02b}$ attaquent par exemple respectivement les bases des transistors Q'A, Q'B, Q'C, Q'D. Enfin, le point de connexion des collecteurs des deux premier et troisième transistors C'A, Q'C et de la résistance R'c forme une première sortie du circuit 64, qui est par exemple connectée à la base du transistor Q'2b du circuit de repliement 62. De même, le point de connexion des collecteurs des deux autres transistors Q'B, Q'D et de la résistance $R'c_b$ forme une deuxième sortie du circuit 64, qui est par exemple connectée à la base du transistor Q'1b du circuit de repliement 62. Pour des raisons d'adaptation d'impédance notamment, les tensions $V_{01}$, $V_{01b}$, $V_{02}$, $V_{02b}$ ne sont pas appliquées directement sur les bases des transistors de la cettute d'interpolation, mais par exemple par l'intermédiaire de transistors montés en suiveurs de tension. Par ailleurs, des diodes, non représentées et ayant une fonction de décalage, permettent de faire en sorte que les références de potentiel sur le premier circuit de repliement 61 soient les mêmes que sur le deuxième circuit de repliement 62, notamment pour compenser les tensions base-émetteur Vbe des transistors des circuits 63, 64 de combinaison de courants.

En ce qui concerne le fonctionnement des circuits 63, 64 de combinaison de courants, il est à noter que les résistances de collecteurs Rc, $Rc_b$ transforment les variations de courants produites par le circuit en tensions applicables à l'entrée des bases des transistors. Un rôle des circuits de combinaison de courants 63, 64 est notamment de créer un décalage des formes d'onde $V_{01}$, $V_{01b}$, $V_{02}$, $V_{02b}$ avant que celles-ci attaquent les entrées du circuit de repliement 62. Ce décalage correspond en fait à la variation $\Delta V$ comprise entre une tension de référence, par exemple 0, et le point d'intersection intermédiaire 21 suivant. C'est encore le décalage entre les formes d'onde repliées directes et décalées. Le fonctionnement d'un circuit 63, 64 peut être décrit en regard des figures 2a et 2b, pour montrer par exemple que la forme d'onde $V_{02}$ se présente décalée sur la base du transistor Q'2 du deuxième circuit de repliement 62 d'un décalage $\Delta V$ par rapport à son entrée sur la base du transistor Q2.

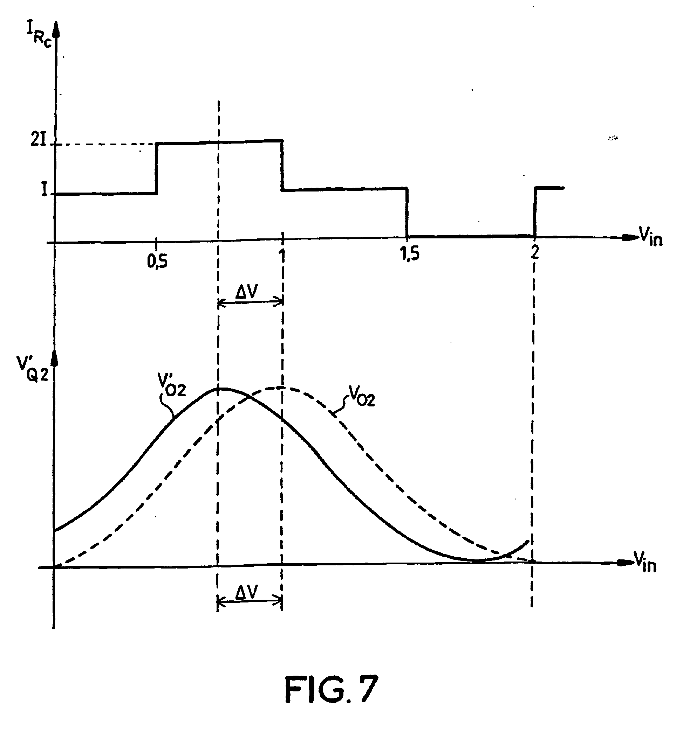

La figure 7 illustre par deux systèmes d'axes le courant $I_{Rc}$ dans la résistance Rc et la tension $V_{Q'2}$ présente sur la base du transistor Q'2. En trait discontinu, la forme d'onde $V_{02}$ est rappelée. Les courant I1 et I2 des sources 631, 632 sont identiques et par exemple égaux à I. Lorsque Vin est compris entre 0 et 0,5 le courant I1 passe dans le transistor QC car la tension $V_{02}$ qui commande ce dernier est supérieure à la tension $V_{02b}$ qui commande le transistor QD, et le courant I2 passe dans le transistor QB car la tension $V_{01b}$ qui commande ce dernier est supérieure à la tension $V_{01}$ qui commande le transistor QA. Le courant $I_{Rc}$ qui passe dans la résistance Rc est donc égal à I. Lorsque Vin est compris entre 0,5 et 1 le courant I1 passe toujours dans le transistor QC car la tension $V_{02}$ qui commande ce dernier reste supérieure à la tension $V_{02b}$ qui commande le transistor QD, mais le courant I2 passe alors dans le transistor QA car la tension $V_{01}$ qui commande ce dernier redevient supérieure à la tension $V_{01b}$ qui commande le transistor QB. Le courant $I_{Rc}$ qui passe dans la résistance Rc est donc égal à 2I. En comparant les tensions $V_{01}$, $V_{01b}$, $V_{02}$, $V_{02b}$ entre elles, on montre aisément, que lorsque Vin est comprise entre 1 et 1,5 le courant $I_{Rc}$ qui passe dans la résistance Rc est égal à I, et que lorsque Vin est comprise entre 1,5 et 2 le courant $I_{Rc}$ qui passe dans la résistance Rc est égal à 0. L'onde de courant $I_{Rc}$ qui traverse la résistance de collecteur Rc est périodique et décalée de $\Delta V$, en avance, par rapport à la forme d'onde $V_{02}$. La forme d'onde $V'_{02}$ générée sur la base du transistor Q'2 du deuxième circuit de repliement 62 est donc décalée, en avance de $\Delta V$, par rapport à la forme d'onde $V_{02}$ présente à l'entrée du transistor Q2 du premier circuit de repliement 61. Ce qui vient d'être décrit pour cette forme d'onde $V_{02}$ s'applique aussi aux autres formes d'onde $V_{01}$, $V_{01b}$, $V_{02b}$. Les ondes repliées $V_{12}$ et $V_{12b}$ obtenues en sortie du deuxième circuit de repliement 62 seront donc décalée, en avance de $\Delta V$, par rapport aux formes d'onde $V_{11}$ et $V_{11b}$ obtenues en sortie du circuit de repliement 61. La cellule d'interpolation de la figure 6 permet donc d'obtenir les quatre tensions repliées $V_{11}$, $V_{11b}$, $V_{12}$, $V_{12b}$. La description du fonctionnement de cette cellule a été faite pour l'obtention des tensions $V_{11}$, $V_{11b}$, $V_{12}$, $V_{12b}$ à partir des tensions $V_{01}$, $V_{01b}$, $V_{02b}$. Le fonctionnement est bien sûr le même quel que soit l'ordre des formes d'onde repliées, les valeurs de référence 0, 0,5, 1 et 1,5 sur lesquelles a été basée cette description étant par ailleurs des valeurs relatives de la tension d'entrée Vin. Ces dernières s'appliquent donc quel que soit l'ordre des tensions repliées. En ce qui concerne la linéarité des signaux évoquée précédemment, il s'agit des portions de signaux compris entre les sommets des formes d'ondes. Cette linéarité est par exemple obtenue en jouant sur les résistances d'émetteurs des transistors.

La cellule d'interpolation décrite par la figure 6 est présentée à titre d'exemple. Cette cellule comporte un circuit de repliement de signal tel qu'illustré par la figure 4 qui donne les formes d'onde repliées décalées $V_{11}$ et $V_{11b}$. Elle comporte aussi une cellule de repliement de signal qui permet d'obtenir des formes d'onde directes $V_{12}$ et $V_{12b}$. Dans cette cellule, le circuit de repliement précédent est complété par des circuits 63, 64 de combinaison de courants qui permettent d'effectuer le décalage $\Delta V$ pour obtenir les formes d'onde repliées directes. Il est bien sûr possible d'utiliser d'autres circuits que ces circuits de combinaison de courants pour obtenir ce décalage.

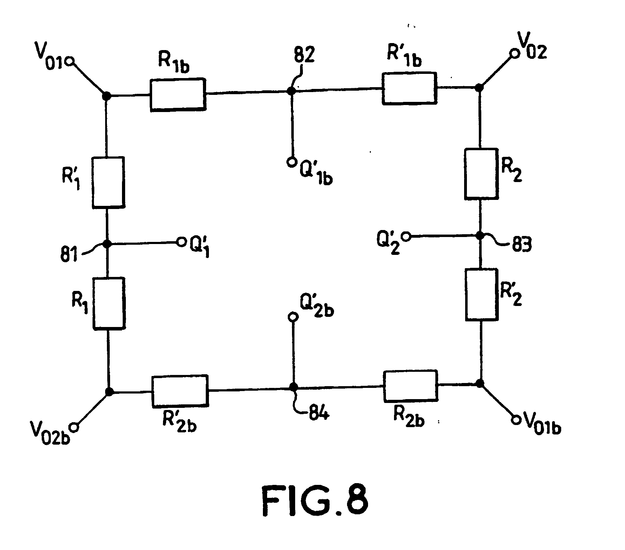

La figure 8 présente un autre mode de réalisation possible d'une cellule de repliement qui permet d'obtenir les formes d'onde directes. Pour simplifier, seul le circuit de décalage a été représenté. Ce circuit comporte par exemple quatre paires de résistances R1 et R'1, R1b et R'1b, R2 et R'2, R2b et R'2b. La tension $V_{01}$ se présente entre une première paire R1, R'1 et une deuxième paire R1b, R'1b. La tension $V_{02}$ se présente entre la deuxième paire R1b, R'1b et une troisième paire R2, R'2. La tension $V_{01b}$ se présente entre la troisième paire R2, R'2 et une quatrième paire R2b, R'2b. La tension $V_{02b}$ se présente entre la quatrième paire R2b, R'2b et la première paire R1, R'1. Le point de connexion 81 entre les deux résistances R1, R'1 de la première paire est relié à la base du transistor Q'1. Le point de connexion 82 entre les deux résistances R1b, R'1b de la deuxième paire est relié à la base du transistor Q'1b. Le point de connexion 83 entre les deux résistances R2, R'2 de la troisième paire est relié à la base du transistor Q'2. Le point de connexion 84 entre les deux résistances R2b, R'2b de la quatrième paire est relié à la base du transistor Q'2b.

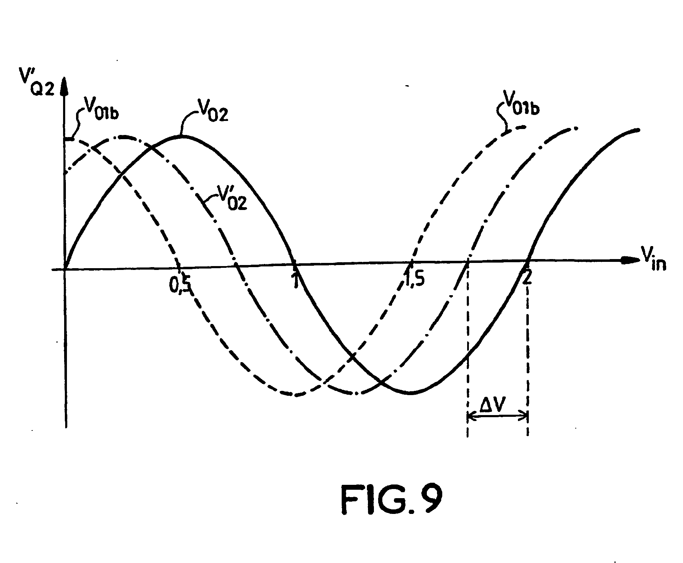

La figure 9 illustre le fonctionnement du montage dans le cas de la tension $V_{02}$. Les résistances peuvent par exemple avoir toutes la même valeur. Dans ce cas, la tension au point 83 présent sur la base du transistor Q'2 est égal à $V'_{02} = (V_{02} + V_{01b})/2$. En se référant aux formes d'onde $V_{01}$, $V_{01b}$, $V_{02}$, $V_{02b}$ telles que présentées par la figure 2a, on obtient en ce point 83 une forme d'onde $V'_{02}$ qui est décalée en avance de $\Delta V$ par rapport à la tension $V_{02}$, obtenant ainsi un résultat analogue à celui du montage de la figure 6. Le montage de la figure 8 a notamment comme avantage qu'il ne comporte que des circuits passifs.

En ce qui concerne la technologie des composants, les transistors utilisés peuvent être notamment des transistors NPN ou PNP ou des transistors NMOS ou PMOS.

En ce qui concerne la rapidité d'une cellule de repliement de signal ou d'interpolation, elle peut être caractérisée par le temps d'établissement des tensions et les temps de propagation lorsque les signaux d'entrée sont des échelons de tension. On peut très simplement optimiser ces paramètres en dimensionnant correctement les courants, notamment dans les paires différentielles des circuits de combinaison de courant 63, 64, car ceux-ci sont avantageusement indépendants pour chaque paire. La vitesse de fonctionnement peut encore être améliorée par l'adjonction de structures en cascades, dites cascodes, dans les collecteurs des paires différentielles, de façon plus optimisée que dans l'art antérieur qui comporte déjà des transistors en cascade, et qui requiert donc des tensions d'alimentations plus importantes. Des circuits selon l'invention permettent donc d'accroître avantageusement la rapidité de fonctionnement, notamment de convertisseurs analogique-numérique sans pour autant accroître de façon significative la tension d'alimentation des circuits. Enfin, les structures utilisées par l'invention sont simples. Les circuits peuvent donc aisément être mis en oeuvre et optimisés.

**Revendications**

1. Cellule de repliement de signal, comportant au moins un circuit de repliement (61), ledit circuit comportant deux paires de branches différentielles (Q1, Q2, Q1b, Q2b) alimentées par une même source de courant (41) reliée à une première borne d'alimentation (42), chaque paire comportant deux transistors, les transistors (Q1, Q2b) d'une paire étant en parallèle sur les transistors de l'autre paire (Q2, Q1b), chaque groupe de deux transistors en parallèle étant relié par une résistance commune respective (R, $R_b$) à une deuxième borne d'alimentation (43), les deux sorties du circuit de repliement ($V_{11}$, $V_{11b}$) étant les collecteurs réunis des deux groupes de transistors en parallèle, **caractérisé en ce qu'**elle comporte en outre un circuit (1) délivrant quatre signaux $V_{01}$, $V_{01b}$, $V_{02}$, $V_{02b}$ variant en fonction d'un signal analogique Vin, les signaux variant en opposition de phase deux à deux, $V_{01}$ et $V_{02}$ étant en opposition de phase avec $V_{01b}$ et $V_{02b}$ respectivement, les deux transistors (Q1, Q2b) d'une paire recevant les deux tensions $V_{01}$, $V_{02b}$ et les deux transistors de l'autre paire (Q2, Q1 b) recevant les deux autres tensions $V_{01b}$, $V_{02}$.

2. Cellule selon la revendication 1, **caractérisée en ce qu'**elle comporte un autre circuit de repliement (62) comportant deux paires de branches différentielles (Q'1, Q'2, Q'1b, Q'2b) alimentées par une même source de courant (41') reliée à une première borne d'alimentation (42), chaque paire comportant deux transistors, les transistors (Q'1, Q'2b) d'une paire étant en parallèle sur les transistors de l'autre paire (Q'2, Q'1b), chaque groupe de deux transistors en parallèle étant relié par une résistance commune respective (R', $R'_b$) à une deuxième borne d'alimentation (43), les deux sorties du circuit de repliement ($V_{12}$, $V_{12b}$) étant les collecteurs réunis des deux groupes de transistors en parallèle, les deux transistors (Q'1, Q'2b) d'une paire recevant les deux tensions $V_{01}$, $V_{02b}$ et les deux transistors de l'autre paire (Q'2, Q'1b) recevant les deux autres tensions $V_{01b}$, $V_{02}$, cet autre circuit recevant sur ses quatre entrées les deux sorties d'un premier circuit de combinaison de courants (63) et les deux sorties d'un deuxième circuit de combinaison de courants (64), chaque circuit de combinaison de courants comportant deux paires différentielles (Q'A et Q'B, Q'C et Q'D) alimentées chacune par une source de courant respective (631, 632, 631', 632') et ayant des résistances de collecteurs communes (Rc, $Rc_b$, R'c, $R'c_b$), l'une des paires (Q'A, Q'B) recevant comme entrées deux tensions d'entrée ($V_{01}$, $V_{01b}$) variant en opposition de phase et l'autre paire (Q'C, Q'D) recevant comme entrées les deux autres tensions ($V_{02}$, $V_{02b}$) variant en opposition de phase, les sortie du circuit de combinaison de courants (63, 64) étant prises sur les résistances de collecteurs (Rc, $Rc_b$, R'c, $R'c_b$) des deux paires différentielles.

3. Cellule selon la revendication 2, **caractérisée en ce que** les résistances de collecteurs (Rc, $Rc_b$, R'c, $R'c_b$) étant reliées à la deuxième borne (43), une diode de décalage (D1, D'1) est câblée entre ces résistances et cette borne.

4. Cellule selon l'une quelconque des revendications 2 ou 3, **caractérisée en ce que** les transistors des paires différentielles (QA et QB, QC et QD) sont reliés aux sources de courant (631, 632) par une résistance d'émetteur.

5. Cellule selon la revendication 1, **caractérisée en ce qu'**elle comporte un autre circuit de repliement (62) comportant deux paires de branches différentielles (Q'1, Q'2, Q'1b, Q'2b) alimentées par une même source de courant (41') reliée à une première borne d'alimentation (42), chaque paire comportant deux transistors, les transistors (Q'1, Q'2b) d'une paire étant en parallèle sur les transistors de l'autre paire (Q'2, Q'1b), chaque groupe de deux transistors en parallèle étant relié par une résistance commune respective (R', $R'_b$) à une deuxième borne d'alimentation (43), les deux sorties du circuit de repliement ($V_{12}$, $V_{12b}$) étant les collecteurs réunis des deux groupes de transistors en parallèle, les deux transistors (Q'1, Q'2b) d'une paire recevant les deux tensions $V_{01}$, $V_{02b}$ et les deux transistors de l'autre paire (Q'2, Q'1b) recevant les deux autres tensions $V_{01b}$, $V_{02}$, cet autre circuit recevant sur ses quatre entrées les quatre sorties d'un circuit comportant quatre paires de résistances (R1 et R'1, R1b et R'1b, R2 et R'2, R2b et R'2b) connectées en série, le point de connexion (81, 82, 83, 84) entre les deux résistances de chaque paire formant les sorties, les point de connexion entre chaque paire formant les entrées recevant les tensions ($V_{01}$, $V_{01b}$, $V_{02}$, $V_{02b}$) variant en fonction du signal analogique Vin, les tensions variant en opposition de phase étant séparées par deux paires de résistances et les tensions variant en quadrature étant séparées par une paire de résistances.

6. Cellule selon la revendication 5, **caractérisée en ce que** les résistances ont la même valeur.

7. Cellule d'interpolation pour un convertisseur analogique-numérique à interpolation, **caractérisée en ce qu'**elle comporte une cellule de repliement selon l'une quelconque des revendications précédentes.

**Patentansprüche**

1. Signalfaltungszelle, die mindestens eine Faltungsschaltung (61) aufweist, wobei die Schaltung zwei Paare von differentiellen Zweigen (Q1, Q2, Q1b, Q2b) aufweist, die von der gleichen Stromquelle (41) gespeist werden, die mit einer ersten Anschlussklemme (42) verbunden ist, wobei jedes Paar zwei Transistoren aufweist, wobei die Transistoren (Q1, Q2b) eines Paars mit den Transistoren (Q2, Q1b) des anderen Paars parallel geschaltet sind, wobei jede Gruppe von zwei parallel geschalteten Transistoren über einen gemeinsamen Widerstand (R bzw. $R_b$) mit einer zweiten Anschlussklemme (43) verbunden ist, wobei die beiden Ausgänge ($V_{11}$, $V_{11b}$) der Faltungsschaltung die vereinten Kollektoren der beiden parallel geschalteten Gruppen von Transistoren sind, **dadurch gekennzeichnet, dass** sie außerdem eine Schaltung (1) aufweist, die vier Signale $V_{01}$, $V_{01b}$, $V_{02}$, $V_{02b}$ liefert, die in Abhängigkeit von einem Analogsignal Vin variieren, wobei die Signale paarweise in Gegenphase variieren, wobei $V_{01}$ und $V_{02}$ zu $V_{01b}$ bzw. $V_{02b}$ in Gegenphase sind, wobei die beiden Transistoren (Q1, Q2b) eines Paars die beiden Spannungen $V_{01}$, $V_{02b}$ und die beiden Transistoren (Q2, Q1b) des anderen Paars die beiden anderen Spannungen $V_{01b}$, $V_{02}$ empfangen.

2. Zelle nach Anspruch 1, **dadurch gekennzeichnet, dass** sie eine weitere Faltungsschaltung (62) aufweist, die zwei differentielle Paare von Zweigen (Q'1, Q'2, Q'1b, Q'2b) aufweist, die von der gleichen Stromquelle (41') gespeist werden, die mit einer ersten Anschlussklemme (42) verbunden ist, wobei jedes Paar zwei Transistoren aufweist, wobei die Transistoren (Q'1, Q'2b) eines Paars mit den Transistoren (Q'2, Q'1b) des anderen Paars parallel geschaltet sind, wobei jede Gruppe von zwei parallel geschalteten Transistoren über einen gemeinsamen Widerstand (R' bzw. $R'_b$) mit einer zweiten Anschlussklemme (43) verbunden ist, wobei die beiden Ausgänge ($V_{12}$, $V_{12b}$) der Faltungsschaltung die vereinten Kollektoren der beiden Gruppen von parallel geschalteten Transistoren sind, wobei die beiden Transistoren (Q'1, Q'2b) eines Paars die beiden Spannungen $V_{01}$, $V_{02b}$ und die beiden Transistoren (Q'2, Q'1b) des anderen Paars die beiden anderen Spannungen $V_{01b}$, $V_{02}$ empfangen, wobei diese weitere Schaltung an ihren vier Eingängen die beiden Ausgangssignale einer ersten Stromkombinationsschaltung (63) und die beiden Ausgangssignale einer zweiten Stromkombinationsschaltung (64) empfängt, wobei jede Stromkombinationsschaltung zwei differentielle Paare (Q'A und Q'B, Q'C und Q'D) aufweist, die je von einer Stromquelle (631, 632, 631', 632') gespeist werden und gemeinsame Kollektorwiderstände (Rc, $Rc_b$, R'c, $R'c_b$) haben, wobei eines der Paare (Q'A, Q'B) als Eingangssignale zwei Eingangsspannungen ($V_{01}$, $V_{01b}$) empfängt, die in Gegenphase variieren, und das andere Paar (Q'C, Q'D) als Eingangssignale die beiden anderen Spannungen ($V_{02}$, $V_{02b}$) empfängt, die in Gegenphase variieren, wobei die Ausgangssignale der Stromkombinationsschaltung (63, 64) an den Kollektorwiderständen (Rc, $Rc_b$, R'c, $R'c_b$) der beiden differentiellen Paare abgenommen werden.

3. Zelle nach Anspruch 2, **dadurch gekennzeichnet, dass** die Kollektorwiderstände (Rc, $Rc_b$, R'c, $R'c_b$) mit der zweiten Klemme (43) verbunden sind, wobei eine Offsetdiode (D1, D'1) zwischen diesen Widerständen und dieser Klemme verkabelt ist.

4. Zelle nach einem der Ansprüche 2 oder 3, **dadurch gekennzeichnet, dass** die Transistoren der differentiellen Paare (QA und QB, QC und QD) über einen Emitterwiderstand mit den Stromquellen (631, 632) verbunden sind.

5. Zelle nach Anspruch 1, **dadurch gekennzeichnet, dass** sie eine weitere Faltungsschaltung (62) aufweist, die zwei Paare von differentiellen Zweigen (Q'1, Q'2, Q'1b, Q'2b) aufweist, die von der gleichen Stromquelle (41') gespeist werden, die mit einer ersten Anschlussklemme (42) verbunden ist, wobei jedes Paar zwei Transistoren aufweist, wobei die Transistoren (Q'1, Q'2b) eines Paars mit den Transistoren (Q'2, Q'1b) des anderen Paars parallel geschaltet sind, wobei jede Gruppe von zwei parallel geschalteten Transistoren über einen gemeinsamen Widerstand (R' bzw. $R'_b$) mit einer zweiten Anschlussklemme (43) verbunden ist, wobei die beiden Ausgänge ($V_{12}$, $V_{12b}$) der Faltungsschaltung die vereinten Kollektoren der beiden Gruppen von parallel geschalteten Transistoren sind, wobei die beiden Transistoren (Q'1, Q'2b) eines Paars die beiden Spannungen $V_{01}$, $V_{02b}$ und die beiden Transistoren (Q'2, Q'1b) des anderen Paars die beiden anderen Spannungen $V_{01b}$, $V_{02}$ empfangen, wobei diese weitere Schaltung an ihren vier Eingängen die vier Ausgangssignale einer Schaltung empfängt, die vier Paare von in Reihe geschalteten Widerständen (R1 und R'1, R1b und R'1b, R2 und R'2, R2b und R'2b) aufweist, wobei der Verbindungspunkt (81, 82, 83, 84) zwischen den beiden Widerständen jedes Paars die Ausgänge bildet, wobei der Verbindungspunkt zwischen jedem Paar die Eingänge bildet, die die Spannungen ($V_{01}$, $V_{01b}$, $V_{02}$, $V_{02b}$) empfangen, die in Abhängigkeit vom Analogsignal Vin variieren, wobei die in Gegenphase variierenden Spannungen von zwei Paaren von Widerständen und die in Quadratur variierenden Spannungen von einem Paar von Widerständen getrennt werden.

6. Zelle nach Anspruch 5, **dadurch gekennzeichnet, dass** die Widerstände den gleichen Wert haben.

7. Interpolationszelle für einen Analog-DigitalWandler mit Interpolation, **dadurch gekennzeichnet, dass** sie eine Faltungszelle nach einem der vorhergehenden Ansprüche aufweist.

**Claims**

1. Signal folding cell, comprising at least one folding circuit (61), the said circuit comprising two pairs of differential branches (Q1, Q2, Q1b, Q2b) supplied by one and the same current source (41) linked to a first supply terminal (42), each pair comprising two transistors, the transistors (Q1, Q2b) of one pair being in parallel with the transistors of the other pair (Q2, Q1b), each group of two transistors in parallel being linked by a respective common resistor ($R$, $R_b$) to a second supply terminal (43), the two outputs of the folding circuit ($V_{11}$, $V_{11b}$) being the joined collectors of the two groups of transistors in parallel, **characterized in that** it furthermore comprises a circuit (1) delivering four signals $V_{01}$, $V_{01b}$, $V_{02}$, $V_{02b}$ varying as a function of an analogue signal Vin, the signals varying in phase opposition pairwise, $V_{01}$ and $V_{02}$ being in phase opposition with $V_{01b}$ and $V_{02b}$ respectively, the two transistors (Q1, Q2b) of one pair receiving the two voltages $V_{01}$, $V_{02b}$ and the two transistors of the other pair (Q2, Q1b) receiving the other two voltages $V_{01b}$, $V_{02}$.

2. Cell according to Claim 1, **characterized in that** it comprises another folding circuit (62) comprising two pairs of differential branches (Q'1, Q'2, Q'1b, Q'2b) supplied by one and the same current source (41') linked to a first supply terminal (42), each pair comprising two transistors, the transistors (Q'1, Q'2b) of one pair being in parallel with the transistors of the other pair (Q'2, Q'1b), each group of two transistors in parallel being linked by a respective common resistor (R', $R'_b$) to a second supply terminal (43), the two outputs of the folding circuit ($V_{12}$, $V_{12b}$) being the joined collectors of the two groups of transistors in parallel, the two transistors (Q'1, Q'2b) of one pair receiving the two voltages $V_{01}$, $V_{02b}$ and the two transistors of the other pair (Q'2, Q'1b) receiving the other two voltages $V_{01b}$, $V_{02}$, this other circuit receiving on its four inputs the two outputs of a first circuit for combining currents (63) and the two outputs of a second circuit for combining currents (64), each circuit for combining currents comprising two differential pairs (Q'A and Q'B, Q'C and Q'D) each supplied by a respective current source (631, 632, 631', 632') and having common collector resistors (Rc, $Rc_b$, R'c, $R'c_b$), one of the pairs (Q'A, Q'B) receiving as inputs two input voltages ($V_{01}$, $V_{01b}$) varying in phase opposition and the other pair (Q'C, Q'D) receiving as inputs the other two voltages ($V_{02}$, $V_{02b}$) varying in phase opposition, the output of the circuit for combining currents (63, 64) being tapped off from the collector resistors (Rc, $Rc_b$, R'c, $R'c_b$) of the two differential pairs.

3. Cell according to Claim 2, **characterized in that** the collector resistors (Rc, $Rc_b$, R'c, $R'c_b$) being linked to the second terminal (43), an offset diode (D1, D'1) is wired between these resistors and this terminal.

4. Cell according to any one of Claims 2 or 3, **characterized in that** the transistors of the differential pairs (QA and QB, QC and QD) are linked to the current sources (631, 632) by an emitter resistor.

5. Cell according to Claim 1, **characterized in that** it comprises another folding circuit (62) comprising two pairs of differential branches (Q'1, Q'2, Q'1b, Q'2b) supplied by one and the same current source (41') linked to a first supply terminal (42), each pair comprising two transistors, the transistors (Q'1, Q'2b) of one pair being in parallel with the transistors of the other pair (Q'2, Q'1b), each group of two transistors in parallel being linked by a respective common resistor (R', $R'_b$) to a second supply terminal (43), the two outputs of the folding circuit ($V_{12}$, $V_{12b}$) being the joined collectors of the two groups of transistors in parallel, the two transistors (Q'1, Q'2b) of one pair receiving the two voltages $V_{01}$, $V_{02b}$ and the two transistors of the other pair (Q'2, Q'1b) receiving the other two voltages $V_{01b}$, $V_{02}$, this other circuit receiving on its four inputs the four outputs of a circuit comprising four pairs of resistors (R1 and R'1, R1b and R'1b, R2 and R'2, R2b and R'2b) connected in series, the point of connection (81, 82, 83, 84) between the two resistors of each pair forming the outputs, the point of connection between each pair forming the inputs receiving the voltages ($V_{01}$, $V_{01b}$, $V_{02}$, $V_{02b}$) varying as a function of the analogue signal Vin, the voltages varying in phase opposition being separated by two pairs of resistors and the voltages varying in quadrature being separated by a pair of resistors.

6. Cell according to Claim 5, **characterized in that** the resistors have the same value.

7. Interpolation cell for an analogue/digital converter with interpolation, **characterized in that** it comprises a folding cell according to any one of the preceding claims.

FIG. 1

FIG.2a

FIG.2b

**FIG.3**

FIG.4

FIG.5

FIG.6

EP 1 076 417 B1

FIG. 7

FIG.8

FIG.9